# EUROPÄISCHE PATENTANMELDUNG

(11) **EP 4 838 561 A1**
(43) Veröffentlichungstag der Anmeldung: **11.11.2026**
(21) Anmeldenummer: 25174691.3
(22) Anmeldetag: 07.05.2025
(51) Int. Cl.: H01L 25/16, H01L 25/00, H10D 80/30, H10F 39/00, H10F 39/95, H10H 29/20, H10H 29/85

(54) **ANWENDUNGSSPEZIFISCHE INTEGRIERTE SCHALTUNG, VERFAHREN ZUM HERSTELLEN EINER ANWENDUNGSSPEZIFISCHEN INTEGRIERTEN SCHALTUNG SOWIE OPTOELEKTRISCHE VORRICHTUNG**

(71) Anmelder: SICK AG, 79183 Waldkirch (DE)
(72) Erfinder: ZWÖLFER, Ulrich, 79183 Waldkirch (DE)
(74) Vertreter: Manitz Finsterwald Patent- und Rechtsanwaltspartnerschaft mbB

(57) **Zusammenfassung**

Die Erfindung betrifft eine anwendungsspezifische integrierte Schaltung (10) mit einem photonischen System (12), aufweisend einen Verdrahtungswafer (20), ein erstes Funktionsmodul (40) und ein oder mehrere weitere Funktionsmodule (40), wobei die Funktionsmodule (40) auf dem Verdrahtungswafer (20) angeordnet sowie durch und mit diesem elektrisch verschaltet sind, wobei ferner die Funktionsmodule (40) als Halbleiterbausteine ausgebildet sind und das erste Funktionsmodul (40) und zumindest eines der ein oder mehreren weiteren Funktionsmodule (40) unterschiedlich sind. Weiter betrifft die Erfindung Verfahren zum Herstellen einer derartigen anwendungsspezifischen integrierten Schaltung sowie eine optoelektrische Vorrichtung (100), aufweisend eine derartige anwendungsspezifische integrierte Schaltung (10), eine Energieversorgung (110) für die integrierte Schaltung (10) sowie eine Datenschnittstelle (112) für ein Ansteuern der anwendungsspezifische integrierten Schaltung (10).

## Beschreibung

Die Erfindung betrifft eine anwendungsspezifische integrierte Schaltung mit einem photonischen System, aufweisend einen Verdrahtungswafer, ein erstes Funktionsmodul und ein oder mehrere weitere Funktionsmodule, wobei die Funktionsmodule auf dem Verdrahtungswafer angeordnet sowie durch und mit diesem elektrisch verschaltet sind, wobei ferner die Funktionsmodule als Halbleiterbausteine ausgebildet sind und das erste Funktionsmodul und zumindest eines der ein oder mehreren weiteren Funktionsmodule unterschiedlich sind. Weiter betrifft die Erfindung ein Verfahren zur Herstellung einer derartigen anwendungsspezifischen integrierten Schaltung sowie eine optoelektrische Vorrichtung, aufweisend eine derartige anwendungsspezifische integrierte Schaltung, eine Energieversorgung für die integrierte Schaltung sowie eine Datenschnittstelle für ein Ansteuern der anwendungsspezifische integrierten Schaltung.

Anwendungsspezifische integrierte Schaltungen (application-specific integrated circuit, ASIC) sowie deren Einsatz sind grundsätzlich bekannt, insbesondere auch in optoelektrischen Vorrichtungen wie beispielsweise Flugzeit-Distanzmessvorrichtungen (time off light, TOF) oder auch als optische Schalteinheiten zum Beispiel in Bewegungsmeldern. Anwendungsspezifische integrierte Schaltungen ermöglichen hierbei insbesondere, die Schaltung genau passend für den vorgesehenen Einsatzzweck auszulegen, wodurch eine hohe Effizienz und Schnelligkeit bei der Ausführung der vorgesehenen Funktion erreicht werden kann. Als integrierte Schaltungen werden ASICs, wie viel andere Chips auch, aufbauend auf einem Wafer aus einem einzigen Halbleitermaterial gefertigt.

Gleichzeitig ist in diesem hohen Grad an Spezifizierung auch ein Nachteil bekannter anwendungsspezifischer integrierte Schaltungen begründet. So sind diese in der Entwicklung meist kostenintensiv. Gleichzeitig ist die Funktion des entsprechenden ASICs nach der Herstellung nicht mehr veränderbar, wodurch eine Flexibilität bezüglich der möglichen Einsatzfelder extrem begrenzt ist.

Insbesondere bei anwendungsspezifischen integrierten Schaltungen für optoelektrische Vorrichtungen hat sich zusätzlich als problematisch herausgestellt, dass bezüglich des für den als Basis verwendeten Wafer verwendeten Halbleitermaterials neben den elektrischen beziehungsweise elektronischen Eigenschaften auch die optischen Eigenschaften, beispielsweise ein wellenlängenabhängiges Absorptions- oder Emissionsverhalten, berücksichtigt werden müssen. Je nach geplantem Einsatzgebiet kann hierbei vorkommen, dass kein optimales Halbleitermaterial gefunden werden kann. Auch eine einfache Änderung insbesondere der optischen Eigenschaften ist zumeist nicht ohne weiteres möglich, da dies üblicherweise eine komplette Neuentwicklung eines entsprechenden ASICs erfordert.

Es ist daher Aufgabe der vorliegenden Erfindung, eine anwendungsspezifische integrierte Schaltung mit einem photonischen System und eine optoelektrische Vorrichtung zu schaffen, mit denen die voranstehend beschriebenen Herausforderungen und Nachteile des Stands der Technik zumindest teilweise behoben werden können. Insbesondere ist es Aufgabe der vorliegenden Erfindung, eine anwendungsspezifische integrierte Schaltung mit einem photonischen System und eine optoelektrische Vorrichtung bereitzustellen, bei denen ein Entwicklungsaufwand hinsichtlich Kosten und Zeit verringert ist, und bei denen Änderungen und/oder Ergänzungen im Aufbau mit hohem Wiederverwendungsgrad durchgeführt werden können.

Die erfindungsgemäße Aufgabe wird durch die Patentansprüche gelöst. Insbesondere wird die Aufgabe gelöst durch eine erfindungsgemäße anwendungsspezifische integrierte Schaltung mit einem photonischen System gemäß Anspruch 1, durch ein Verfahren zum Herstellen einer anwendungsspezifischen integrierten Schaltung gemäß Anspruch 6, sowie durch eine erfindungsgemäße optoelektrische Vorrichtung gemäß Anspruch 8. Weiterbildungen der Erfindung ergeben sich aus den Unteransprüchen, der Beschreibung und den Zeichnungen. Dabei gelten Merkmale und Vorteile, die mit Bezug auf die integrierte Schaltung beschrieben sind, auch für das erfindungsgemäße Verfahren und die erfindungsgemäße optoelektrische Vorrichtung und jeweils umgekehrt, soweit technisch sinnvoll und möglich.

Gemäß einem ersten Aspekt der Erfindung wird die Aufgabe gelöst durch eine anwendungsspezifische integrierte Schaltung mit einem photonischen System. Die erfindungsgemäße anwendungsspezifische integrierte Schaltung ist dadurch gekennzeichnet, dass sie einen Verdrahtungswafer, ein erstes Funktionsmodul und ein oder mehrere weitere Funktionsmodule aufweist, wobei die Funktionsmodule getrennt vom Verdrahtungswafer gefertigt sind, und wobei zur Bildung der anwendungsspezifischen integrierten Schaltung die Funktionsmodule auf dem Verdrahtungswafer platziert sowie durch und mit diesem elektrisch verschaltet sind, wobei ferner die Funktionsmodule als Halbleiterbausteine ausgebildet sind und das erste Funktionsmodul und zumindest eines der ein oder mehreren weiteren Funktionsmodule unterschiedlich sind, und dass das photonische System zumindest durch das erste Funktionsmodul gebildet ist, wobei das erste Funktionsmodul als Photonikmodul zum Erzeugen und/oder Empfangen und/oder Modulieren und/oder Leiten von Licht ausgebildet ist.

Die erfindungsgemäße anwendungsspezifische integrierte Schaltung ist für einen Einsatz in einer optoelektrischen Vorrichtung vorgesehen, also einer Vorrichtung mit der Licht empfangen, ausgesendet oder anderweitig moduliert und/oder geleitet werden kann, beispielsweise für eine vorrichtungsinterne Datenübertragung. Die erfindungsgemäße anwendungsspezifische integrierte Schaltung kann insbesondere auch als ASIC bezeichnet werden.

Im Gegensatz zu bekannten anwendungsspezifischen integrierten Schaltungen des Stands der Technik, die aufbauend auf einem Wafer aus einem einzigen Halbleitermaterial gefertigt sind, weist die erfindungsgemäße integrierte Schaltung einen Verdrahtungswafer auf, auf dem dann zumindest zwei verschiedene Funktionsmodule platziert werden. Hierbei sind der Verdrahtungswafer und die Funktionsmodule getrennt voneinander gefertigt. Dadurch kann insbesondere ermöglicht werden, auf die jeweiligen spezifischen Anforderungen bei der Herstellung, insbesondere bei der Herstellung der Funktionsmodule, einzugehen und diese zu berücksichtigen. Als Beispiel sind hier ein für die Bereitstellung der jeweiligen Funktion des Funktionsmoduls erforderlicher Schichtaufbau des Funktionsmoduls oder auch ein Einsatz insbesondere verschiedener Halbleitermaterialien für die einzelnen Funktionsmodule zu nennen. Hierbei kann das im Funktionsmodul verwendete Halbleitermaterial auch von demjenigen des Verdrahtungswafers abweichen. Das Platzieren auf dem Verdrahtungswafer beinhaltet insbesondere ein physisches Absetzen des Funktionsmoduls auf einer Oberfläche des Verdrahtungswafers. Nach dem Platzieren erfolgt noch eine elektrische Verschaltung der Funktionsmodule mit und durch den Verdrahtungswafer. Die einzelnen Funktionsmodule und der Verdrahtungswafer weisen hierfür geeignete, bevorzugt standardisierte Schnittstellen auf. Dadurch bilden die Funktionsmodule mit dem Verdrahtungswafer eine elektronische Einheit, nämlich die erfindungsgemäße anwendungsspezifische integrierte Schaltung.

Die Schnittstellen zwischen dem Verdrahtungswafer und den Funktionsmodulen können für alle Funktionsmodule identisch ausgebildet sein. Alternativ können sie auch spezifisch für einzelne Funktionsmodule oder Klassen von Funktionsmodulen gleich ausgebildet sein. Eine Klasse von Funktionsmodulen im Sinne der Erfindung können dabei insbesondere Funktionsmodule darstellen, die zumindest bezüglich einer Eigenschaft eine Ähnlichkeit zueinander aufweisen, beispielsweise verschiedene Photonikmodule zum Empfangen von Licht unterschiedlicher Wellenlängen, oder Funktionsmodule die die gleiche Funktionalität bereitstellen, aber in verschiedenen Ausgestaltungen vorliegen wie zum Beispiel Speicherbausteine mit unterschiedlicher Speicherkapazität.

Die Funktionsmodule können auch als Chiplets bezeichnet werden. Die einzelnen Funktionsmodule können verschiedene Funktionalitäten zur Verfügung stellen, wie beispielsweise volatile und/oder nicht-volatile Speicherbausteine, Strom und/oder Spannungsversorgung beziehungsweise deren Kontrollinstanzen und/oder Schnittstellen, oder auch gesamte Prozessorbausteine. Durch den Einsatz der Funktionsmodule für die verschiedenen Funktionalitäten ist es ferner möglich, für jedes der Funktionsmodule unabhängig vom Material des Verbindungswafers das entsprechend passendste Halbleitermaterial zu verwenden. Mögliche derartige Halbleitermaterialien umfassen als Material zum Beispiel Silizium (Si), Germanium (Ge), Galliumarsenid (GaAs), Indiumphosphid (InP), Galliumnitrid (GaN), oder diamantartigen Kohlenstoff (DLC, diamond like carbon). Das jeweils eingesetzte Halbleitermaterial kann ein einziges Material sein, aber auch aus mehreren Materialien bestehen, die beispielsweise schichtartig aufeinander angeordnet sind. Eine Einschränkung auf ein einziges Halbleitermaterial als Grundlage der gesamten integrierten Schaltung, wie bei bekannten ASICs des Stands der Technik, besteht somit nicht. Eine erfindungsgemäße anwendungsspezifische integrierte Schaltung kann somit insbesondere eine heterogene integrierte Schaltung darstellen.

Das Platzieren der Funktionsmodule auf dem Verdrahtungswafer kann durch ein sogenanntes Pick-and-Place-Verfahren erfolgen. Dadurch ist eine Herstellung der erfindungsgemäßen anwendungsspezifischen integrierten Schaltung mit niedrigen bis hohen Stückzahlen möglich und rentabel, insbesondere da dadurch beispielsweise gleichzeitig viele einzelne Funktionsmodule auf einer Vielzahl an Verdrahtungswafern platziert werden kann, wodurch eine simultane Herstellung einer großen Anzahl an erfindungsgemäßen anwendungsspezifischen integrierten Schaltungen ermöglicht ist. Weiter lassen sich damit Miniaturisierung, Verlustleistungsminimierung und eine massive Reduktion von EMV-Abstrahlsörungen deutlich besser als bei bekannten auf einem einzelnen Wafer basierenden ASICs erreichen beziehungsweise beherrschen.

Weiter ist bei der erfindungsgemäßen anwendungsspezifischen integrierten Schaltung vorgesehen, dass das photonische System zumindest durch das erste Funktionsmodul gebildet ist, wobei das erste Funktionsmodul als Photonikmodul zum Erzeugen und/oder Empfangen und/oder Modulieren und/oder Leiten von Licht ausgebildet ist. Licht im Sinne der vorliegenden Erfindung umfasst insbesondere sichtbares sowie UV- und IR-Licht, jedoch auch langwelligere oder kurzwelligere elektromagnetische Strahlung wie Mikrowellen oder Röntgenstrahlung. Auf diese Weise kann das photonische System direkt durch die erfindungsgemäße anwendungsspezifische integrierte Schaltung bereitgestellt werden.

Durch die oben beschriebenen vorteilhaften Eigenschaften des Aufbaus der erfindungsgemäßen integrierten Schaltung aus dem Verbindungswafer und den darauf angeordneten Funktionsmodulen kann das erste Funktionsmodul, also das Photonikmodul, speziell auf das bereitzustellende photonische System abgestimmt vorgesehen werden, insbesondere beispielsweise hinsichtlich des als Basis für das erste Funktionsmodul verwendete Halbleitermaterial. So kann beispielsweise in einem ersten Funktionsmodul, das als photonisches System zum Empfangen beziehungsweise Detektieren von Licht vorgesehen ist, für eine hohe Sensitivität im sichtbaren Bereich bei etwa 700 nm basierend auf Silizium, für eine hohe Sensitivität im IR-Bereich bei etwa 1300 nm basierend auf Indiumphosphid (InP) aufgebaut sein.

Da, wie bereits dargelegt, Funktionsmodule mit gleicher Funktionalität bevorzugt die gleiche Schnittstelle mit dem Verdrahtungswafer aufweisen, können durch Austausch des verwendeten ersten Funktionsmodul auch Kleinserien beider Varianten hergestellt werden, ohne die erfindungsgemäße anwendungsspezifische integrierte Schaltung von Grund auf neu planen und designen zu müssen. Ein hoher Kosten- und Zeitaufwand bei der Herstellung der jeweiligen erfindungsgemäßen integrierten Schaltung kann so vermieden werden.

Zusammenfassend kann durch die vorliegende Erfindung eine erfindungsgemäße anwendungsspezifische integrierte Schaltung bereitgestellt werden, die besonders gut auf die jeweiligen Anforderungen, sowohl hinsichtlich des photonischen Systems als auch hinsichtlich der restlichen elektrischen Funktionalitäten, angepasst bereitgestellt werden kann. Ferner können Änderungen an der erfindungsgemäßen integrierten Schaltung besonders einfach durch Austausch einzelner Funktionsmodule vorgenommen werden, und eine Notwendigkeit einer völligen Neuentwicklung der anwendungsspezifischen integrierten Schaltung kann vermieden werden.

Weiter kann bei der erfindungsgemäßen anwendungsspezifischen integrierten Schaltung vorgesehen sein, dass das Photonikmodul zumindest eine der folgenden Funktionalitäten bereitstellt:
- Detektieren von Licht,
- Aussenden von Licht, bevorzugt von Laserlicht,
- optisches Verstärken von Licht,
- Leiten von Licht,
- Verändern einer Phase und/oder einer Wellenlänge und/oder einer Polarisation von Licht.

Diese Liste ist nicht abgeschlossen, so dass insbesondere auch weitere Funktionalitäten, die im Zusammenhang mit einem photonischen System stehen, durch das Photonikmodul als erstes Funktionsmodul bereitgestellt werden können, soweit technisch sinnvoll und möglich.

Auch kann die erfindungsgemäße anwendungsspezifische integrierte Schaltung dadurch gekennzeichnet sein, dass das Photonikmodul zum Beeinflussen von optische Eigenschaften des Photonikmoduls eine Reflexionsbeschichtung und/oder eine Antireflexionsbeschichtung und/oder einen Filter aufweist. Durch derartige spezielle Ausgestaltungen des Photonikmoduls können die optischen Eigenschaften des Photonikmoduls auf besonders einfache Art und Weise beeinflusst werden, ohne den grundlegenden Aufbau bezüglich eines aus dem entsprechenden Halbleitermaterial gefertigten Kerns des Photonikmoduls ändern zu müssen. Eine Reflexions- beziehungsweise Antireflexionsbeschichtung kann insbesondere auf einer Ober- und/oder Unterseite des Photonikmoduls angeordnet sein. Ein Filter kann wiederum für eine ausgewählte Wellenlänge oder einen ausgewählten Wellenlängenbereich durchlässig sein, und so beispielsweise bei einem Photonikmodul, das zum Detektieren von Licht ausgestaltet ist, dessen Sensitivität für bestimmte Wellenlängen erhöhen und für andere verringern.

Ferner kann bei einer Ausgestaltung der anwendungsspezifischen integrierten Schaltung vorgesehen sein, dass das Photonikmodul ein Detektieren von Licht ermöglicht und dafür eine oder mehrere Fotodioden und/oder eine oder mehrere Avalanche-Fotodioden, insbesondere Einzelphoton-Avalanche-Fotodioden, aufweist. Fotodioden, Avalanche-Fotodioden oder auch Einzelphoton-Avalanche-Fotodioden sind bekannte Halbleiterbauelemente, die zum Detektieren von Licht befähigt sind. Durch eine Ausgestaltung des Photonikmoduls mit wenigstens einem dieser Bauelemente kann diese Funktionalität einer Detektion von Licht auch für das Photonikmodul ermöglicht werden.

Darüber hinaus kann die erfindungsgemäße anwendungsspezifische integrierte Schaltung auch dadurch gekennzeichnet sein, dass mehrere Fotodioden und/oder mehrere Avalanche-Fotodioden im Photonikmodul in einer Reihe oder in einem mehrreihigen Array angeordnet sind. Durch das Bereitstellen mehrerer Fotodioden beziehungsweise Avalanche-Fotodioden, insbesondere auch Einzelphoton-Avalanche-Fotodioden, kann eine Sensitivität des Photonikmoduls beim Detektieren von Licht erhöht werden und/oder eine Ortsauflösung bezüglich des detektierten Lichts ermöglicht werden. Eine Anordnung der im Photonikmodul vorhandenen Fotodioden, unabhängig von ihrer Ausgestaltung, in einer Reihe oder in einem mehrreihigen Array stellt eine besonders platzsparende Anordnung dieser Bauelemente dar. Ferner kann dadurch auch ein Auslesen der Signale und/oder eine Analyse dieser Signale vereinfacht werden.

Weiter kann bei der erfindungsgemäßen anwendungsspezifischen integrierten Schaltung vorgesehen sein, dass wenigstens eines der ein oder mehreren weiteren Funktionsmodule zumindest eine der folgenden Funktionalitäten bereitstellt:
- TDC (time to digital converter),
- TIA (transimpedance amplifier),
- ADC (analog to digital converter),
- Kontrolleinheit (Datennahme),
- Spannungsversorgung,
- Kontrolleinheit (Spannungsversorgung),
- Schnittstelleneinheit (Spannungsversorgung),
- Stromversorgung,
- Kontrolleinheit (Stromversorgung),
- Schnittstelleneinheit (Stromversorgung),
- Prozessorbaustein ohne KI,
- Prozessorbaustein mit KI,
- volatiler Speicherbaustein,
- nicht-volatiler Speicherbaustein.

Diese Liste ist nicht abgeschlossen, so dass insbesondere auch weitere Funktionalitäten durch ein Funktionsmodul bereitgestellt werden können, soweit technisch sinnvoll und möglich.

Gemäß einer weiteren Ausführungsform kann bei der erfindungsgemäßen anwendungsspezifische integrierte Schaltung vorgesehen sein, dass der Verdrahtungswafer Silizium aufweist, insbesondere aus Silizium, bevorzugt aus monokristallinen Silizium, besteht. Der Verdrahtungswafer ist in der erfindungsgemäßen integrierten Schaltung das größte einzelne Bauteil aus einem Halbleitermaterial. Silizium wiederum stellt in der Halbleiterindustrie ein weit verbreitetes und vergleichsweise günstiges Material dar. Durch einen Einsatz von Silizium als Material für den Verdrahtungswafer können somit Kosten gespart, und weiter auf bekannte und etablierte Herstellungsverfahren zurückgegriffen werden.

Gemäß einem zweiten Aspekt der Erfindung wird die Aufgabe gelöst durch ein Verfahren zum Herstellen einer anwendungsspezifischen integrierten Schaltung mit einem photonischen System gemäß dem ersten Aspekt der Erfindung, gekennzeichnet durch folgende Schritte:
a) Erstellen eines Anforderungsprofils an die herzustellende anwendungsspezifische integrierte Schaltung,
b) Auswahl eines geeigneten Verdrahtungswafers sowie von zwei oder mehr geeigneten Funktionsmodulen basierend auf dem in Schritt a) erstellten Anforderungsprofils, wobei die Funktionsmodule als Halbleiterbausteine ausgebildet und getrennt vom Verdrahtungswafer gefertigt sind,
c) Platzieren der in Schritt b) ausgewählten Funktionsmodule auf dem in Schritt b) ausgewählten Verdrahtungswafer, bevorzugt in einem Pick-and-Place-Verfahren,
d) Elektrisches Verschalten der in Schritt c) platzierten Funktionsmodule mit und durch den Verdrahtungswafer,
wobei ein erstes Funktionsmodul und zumindest eines der ein oder mehreren weiteren Funktionsmodule unterschiedlich sind, und wobei zumindest das erste Funktionsmodul das photonische System bildet, wobei das erste Funktionsmodul als Photonikmodul zum Erzeugen und/oder Empfangen und/oder Modulieren und/oder Leiten von Licht ausgebildet ist.

Das erfindungsgemäße Verfahren gemäß dem zweiten Aspekt ist zur Herstellung einer erfindungsgemäßen anwendungsspezifischen integrierten Schaltung gemäß dem ersten Aspekt der Erfindung vorgesehen. Somit können durch das erfindungsgemäße Verfahren gemäß dem zweiten Aspekt dieselben Merkmale und Vorteile ermöglicht werden, wie sie voranstehend mit Bezug auf die anwendungsspezifische integrierte Schaltung gemäß dem ersten Aspekt der Erfindung beschrieben worden sind.

Im ersten Schritt a) des erfindungsgemäßen Verfahrens wird ein Anforderungsprofil erstellt, in dem insbesondere die Eigenschaften, Merkmale und/oder Funktionalitäten der herzustellenden anwendungsspezifischen integrierten Schaltung enthalten sind. Hierbei kann beispielsweise hinsichtlich des photonischen Systems angegeben sein, ob es zum Empfangen, zum Senden, zum Modulieren und/oder zum Leiten von Licht ausgebildet sein soll und/oder ob und wenn ja welche wellenlängenspezifischen Eigenschaften das photonische System, und damit insbesondere das als Photonikmodul ausgebildete erste Funktionsmodul, aufweisen soll. Darüber hinaus kann das Anforderungsprofil auch weitere Elemente und deren Spezifikationen beinhalten, beispielsweise das Bereitstellen einer elektrischen Energieversorgung, eines Prozessorbausteins, eines Speicherbausteins, oder komplexer Funktionalitäten wie beispielsweise ein TDC, ein ADC, ein TIA oder ähnliches. Auch Kontrolleinheiten für verschiedenste Funktionen der integrierten Schaltung selbst, wie zum Beispiel eine Strom- oder Spannungsversorgung oder eine Datennahme, können im Anforderungsprofil spezifiziert werden.

Im folgenden Schritt b) werden Komponenten für die anwendungsspezifische integrierte Schaltung ausgewählt, mit denen das in Schritt a) erstellte Anforderungsprofil erfüllt oder zumindest im Wesentlichen erfüllt werden kann. Als Komponenten werden insbesondere ein geeigneter Verdrahtungswafer und ebenfalls entsprechend geeignete Funktionsmodule ausgewählt. Durch ein getrenntes Fertigen des Verdrahtungswafers und der Funktionsmodule kann ermöglicht werden, für jede der Anforderungen eine Komponenten gefertigt aus dem passendsten Material, insbesondere Halbleitermaterial, auszuwählen. Ein Einschränkung des Halbleitermaterials der ausgewählten Funktionsmodule auf das Halbleitermaterial des Verdrahtungswafers kann so vermieden werden.

Es werden zumindest zwei Funktionsmodule ausgewählt, wobei ein erstes Funktionsmodul als Photonikmodul ausgebildet und unterschiedlich zu dem zumindest einen weiteren Funktionsmodul ist. Das Photonikmodul ist zum Erzeugen und/oder Empfangen und/oder Modulieren und/oder Leiten von Licht ausgebildet. Somit wird das photonische System der anwendungsspezifischen integrierten Schaltung zumindest durch dieses Photonikmodul gebildet.

Ein Platzieren der in Schritt b) ausgewählten Funktionsmodule auf dem ebenfalls in Schritt b) ausgewählten Verdrahtungswafer erfolgt im nächsten Schritt c). Bevorzugt kann das Platzieren in einem sogenannten "Pick-and-Place"-Verfahren durchgeführt werden. Weiter kann vorgesehen sein, dass in Schritt c) nicht nur ein Verdrahtungswafer mit den entsprechenden Funktionsmodulen bestückt wird, sondern parallel eine Vielzahl von Verdrahtungswafern. Hierbei ist möglich, ausschließlich identische anwendungsspezifische integrierte Schaltungen herzustellen, mit anderen Worten, auf allen Verdrahtungswafern dieselben Funktionsmodulen in derselben Anordnung zu platzieren. Alternativ können in einem Bestückungsvorgang auch für viele verschiedene anwendungsspezifische integrierte Schaltungen parallel Funktionsmodule auf Verdrahtungswafern platziert werden, die sich in diesem Fall für jede anwendungsspezifische integrierte Schaltungen in Art und/oder Anordnung unterscheiden können.

Im letzten Schritt d) des erfindungsgemäßen Verfahrens werden die Funktionsmodule noch auf und mit dem Verdrahtungswafer elektrisch verschaltet. Dieses Verschalten kann zum Beispiel durch Bonden mit einem Draht und/oder durch Verlöten erfolgen. Durch das Verschalten können die einzelnen Funktionsmodule beispielsweise mit elektrischer Energie versorgt werden, aber auch zum Beispiel Signale austauschen, sowohl miteinander als auch mit und/oder über den Verdrahtungswafer. Auf diese Weise bilden die Funktionsmodule und der Verdrahtungswafer elektrisch und elektronisch eine Einheit, die Herstellung der anwendungsspezifischen integrierten Schaltung ist abgeschlossen.

Das erfindungsgemäße Verfahren kann ferner aufweisen, dass bei einer Änderung des in Schritt a) erstellten Anforderungsprofils im folgenden Schritt b) basierend auf dieser Änderung eine Anpassung der Auswahl der Funktionsmodule erfolgt. Wie voranstehend bereits ausgeführt werden die zur Herstellung der anwendungsspezifischen integrierten Schaltung verwendeten Komponenten, also der Verdrahtungswafer und insbesondere die einzelnen Funktionsmodule, getrennt voneinander gefertigt. Dies ermöglicht in dieser Ausgestaltungsform des erfindungsgemäßen Verfahrens, auf eine Änderung des im Schritt a) erstellten Anforderungsprofil besonders flexibel reagieren zu können. Insbesondere kann ermöglicht werden, in Schritt b) die ausgewählten Funktionsmodule an die neuen Anforderungen anzupassen. Beispielsweise kann bei einer Änderung einer geforderten wellenlängenabhängigen Empfindlichkeit einer Detektion von Licht nur das entsprechende Photonikmodul, das diese Funktionalität bereitstellt, ausgetauscht werden, und sämtliche anderen Funktionsmodule, die beispielsweise als Funktionalität eine Versorgung mit elektrischer Energie bereitstellen und/oder als Prozessorbaustein und/oder Speicherbaustein eine erste Auswertung der Messdaten ermöglichen, unverändert beibehalten werden. Eine Anpassung der gesamten anwendungsspezifischen integrierten Schaltung an sich ändernde Anforderungen kann somit besonders einfach und effektiv ermöglicht werden, insbesondere ohne eine komplette Neuentwicklung der anwendungsspezifischen integrierten Schaltung zu erfordern.

Gemäß einem dritten Aspekt der Erfindung wird die Aufgabe gelöst durch eine optoelektrische Vorrichtung, aufweisend eine anwendungsspezifische integrierte Schaltung, eine Energieversorgung für die anwendungsspezifische integrierte Schaltung sowie eine Datenschnittstelle für ein Ansteuern der anwendungsspezifischen integrierten Schaltung. Die optoelektrische Vorrichtung gemäß dem zweiten Aspekt der Erfindung ist dadurch gekennzeichnet, dass die anwendungsspezifische integrierte Schaltung als eine anwendungsspezifische integrierte Schaltung mit einem photonischen System gemäß dem ersten Aspekt der Erfindung ausgebildet und/oder durch ein Verfahren gemäß dem zweiten Aspekt der Erfindung hergestellt ist.

Eine optoelektrische Vorrichtung gemäß dem dritten Aspekt der Erfindung weist eine anwendungsspezifische integrierte Schaltung gemäß dem ersten Aspekt der Erfindung auf. Alternativ oder zusätzlich kann die optoelektrische Vorrichtung gemäß dem dritten Aspekt der Erfindung auch unter Einsatz eines Verfahrens gemäß dem zweiten Aspekt der Erfindung hergestellt sein. Sämtliche Merkmale und Vorteile, die voranstehend mit Bezug auf eine erfindungsgemäße anwendungsspezifische integrierte Schaltung gemäß dem ersten Aspekt der Erfindung sowie mit Bezug auf ein erfindungsgemäßes Verfahren gemäß dem zweiten Aspekt der Erfindung beschrieben wurden, können somit auch durch eine erfindungsgemäße optoelektrische Vorrichtung gemäß dem zweiten Aspekt der Erfindung bereitgestellt beziehungsweise ermöglicht werden.

Eine erfindungsgemäße optoelektrische Vorrichtung kann ferner auch dadurch gekennzeichnet sein, dass das photonische System der anwendungsspezifischen integrierten Schaltung durch zumindest ein zum Detektieren von Licht ausgebildetes Photonikmodul gebildet ist. Mit anderen Worten, durch die in der optoelektrischen Vorrichtung verbauten erfindungsgemäße integrierte Schaltung ist die gesamte optoelektrische Vorrichtung als Detektor für Licht ausgebildet. Ein Einsatz der erfindungsgemäßen optoelektrischen Vorrichtung in einer Vielzahl an Anwendungsgebieten kann dadurch ermöglicht werden, beispielsweise in Bewegungsmeldern, in Abstandsmessgeräten, in lichtbasierten Kommunikationseinheiten und/oder in Kameras.

Weiter kann bei der erfindungsgemäßen optoelektrischen Vorrichtung vorgesehen sein, dass eine wellenlängenabhängige Empfindlichkeit der optoelektrischen Vorrichtung durch ein zum Detektieren von Licht eingesetztes Detektions-Halbleitermaterial des Photonikmoduls eingestellt ist. Das Photonikmodul ist als ein Halbleiterbaustein ausgebildet. Somit wird für die Detektion von Licht ein Halbleitermaterial eingesetzt. Halbleitermaterialien weisen wiederum die Eigenschaft auf, dass eine wellenlängenabhängige Empfindlichkeit für eine Detektion von Licht sehr vom jeweiligen Detektions-Halbleitermaterial abhängt. So ist beispielsweise Silizium für Wellenlängen zwischen ca. 190 nm und ca. 1100 nm empfindlich, Blei(II)Sulfid (PbS) hingegen für Wellenlängen zwischen ca. 1000 nm und ca. 3500 nm. Durch Auswahl eines Photonikmoduls mit passendem Detektions-Halbleitermaterial kann somit besonders einfach eine wellenlängenabhängige Empfindlichkeit der optoelektrischen Vorrichtung eingestellt werden.

Darüber hinaus kann eine Ausführungsform der optoelektrischen Vorrichtung dadurch gekennzeichnet sein, dass für eine hohe Empfindlichkeit der optoelektrischen Vorrichtung im Bereich von sichtbarem Licht um 700 nm Silizium ein Photonikmodul mit Silizium (Si) als Detektions-Halbleitermaterial verwendet ist, und dass für eine hohe Empfindlichkeit der optoelektrischen Vorrichtung im Bereich von Infrarot-Licht um 1300 nm ein Photonikmodul mit Indiumphosphid (InP) als Detektions-Halbleitermaterial verwendet ist. Allein durch Austausch des Photonikmoduls, und insbesondere bevorzugt ohne Änderung der restlichen Funktionsmodule, kann somit das photonische System der anwendungsspezifischen Schaltung, und damit die gesamte optoelektrische Vorrichtung, auf neue, sich ändernde Anforderungen abgestimmt bereitgestellt werden. Insbesondere ist möglich, in einer bevorzugt ansonsten unveränderten optoelektrischen Vorrichtung durch Einsatz eines entsprechend gestalteten Photonikmoduls basierend auf Silizium als Detektions-Halbleitermaterial eine hohe Sensitivität im sichtbaren Bereich bei etwa 700 nm, und durch Einsatz eines entsprechend gestalteten Photonikmoduls basierend auf Indiumphosphid (InP) als Detektions-Halbleitermaterial eine hohe Sensitivität im IR-Bereich bei etwa 1300 nm bereitzustellen.

In einer Ausführungsform der erfindungsgemäßen optoelektrischen Vorrichtung kann ferner vorgesehen sein, dass die optoelektrische Vorrichtung für einen Einsatz in einer Flugzeit-Distanzmessvorrichtung vorgesehen ist, und wobei das Photonikmodul eine oder mehrere Avalanche-Fotodioden, insbesondere Einzelphoton-Avalanche-Fotodioden, aufweist, und die weiteren Funktionsmodule der integrierten Schaltung zumindest folgende Funktionalitäten bereitstellen:
- TDC (time to digital converter),
- Kontrolleinheit (Datennahme),
- Stromversorgung,
- Kontrolleinheit (Stromversorgung),
- Schnittstelleneinheit (Stromversorgung).

Für eine Flugzeit-Distanzmessung (TOF - time of flight) wird eine Laufzeit eines Lichtsignals gemessen, um eine Distanz zu einem Objekt zu ermitteln. Dafür wird ein Lichtsignal, zumeist ein Laserstrahl oder ein Laserimpuls, durch eine entsprechende Lichtquelle die Flugzeit-Distanzmessvorrichtung ausgesendet, und ein am entsprechenden Objekt reflektierter Teil dieses Lichts wieder detektiert. Gleichzeitig wird eine Zeit gemessen, die zwischen Aussenden des Lichtsignals und Detektion des reflektierten Teils des Lichtsignals verstreicht. Zusammen mit der bekannten Geschwindigkeit des Lichts kann dann die Distanz des Objekts zur Messvorrichtung ermittelt werden.

Durch ein Photonikmodul mit einer oder mehreren Avalanche-Fotodioden, bevorzugt Einzelphoton-Avalanche-Fotodioden, kann durch die erfindungsgemäße anwendungsspezifische integrierte Schaltung das Detektieren des reflektierten Lichtsignals ermöglicht werden. Avalanche-Fotodioden, insbesondere Einzelphoton-Avalanche-Fotodioden, stellen hierbei besonders sensitive Lichtdetektoren dar, die für das Detektieren des oftmals schwachen Signal des am Objekt reflektierten Lichts besonders geeignet sind. Durch den Einsatz mehrerer derartiger Avalanche-Fotodioden, bevorzugt angeordnet in einer Reihe oder einem mehrreihigen Array, kann die Sensitivität noch weiter gesteigert werden.

Ferner sind als Teil der erfindungsgemäßen integrierten Schaltung durch weitere Funktionsmodule vorgesehen die als Funktionalitäten noch einen TDC (time to digital converter), eine Kontrolleinheit für die Datennahme, sowie eine Spannungsversorgung nebst entsprechender Schnittstelle bereitstellen. Durch das TDC-Funktionsmodul wird, gesteuert und ausgelesen durch die Kontrolleinheit für die Datennahme, die verstrichene Zeit zwischen Aussenden des Lichtsignals und Detektion des reflektierten Lichtsignals gemessen und als digitaler Wert zur Verfügung gestellt.

Die Stromversorgung und die entsprechend zugehörige Schnittstelle und Kontrolleinheit sorgen für die Versorgung der erfindungsgemäßen integrierten Schaltung mit elektrischer Energie. Diese die Stromversorgung betreffenden Funktionalitäten können durch jeweils ein Funktionsmodul, wahlweise aber auch durch ein oder mehrere Funktionsmodule mit kombinierten Funktionalitäten bereitgestellt werden.

Zusammenfassend kann in einer erfindungsgemäßen optoelektrischen Vorrichtung durch den Einsatz einer erfindungsgemäßen anwendungsspezifischen integrierten Schaltung die Gesamtfunktionalität einer Flugzeit-Distanzmessung besonders einfach und kompakt bereitgestellt werden. Beispielsweise bei Änderung der Anforderungsparameter ist darüber hinaus durch einen Austausch des entsprechenden Funktionsmoduls der erfindungsgemäßen anwendungsspezifischen integrierten Schaltung eine Anpassung der erfindungsgemäßen optoelektrischen Vorrichtung mit besonders geringem Aufwand möglich, ohne insbesondere die integrierte Schaltung von Grund auf neu designen zu müssen. Beispielhaft kann so zum Beispiel durch einen Wechsel des Photonikmoduls eine Änderung der Sensitivität bezüglich einer Wellenlänge des Lichts erfolgen, oder eine Empfindlichkeit durch eine Erhöhung oder Erniedrigung einer Anzahl der Avalanche-Fotodioden verändert werden. Ebenfalls lediglich beispielhaft ist auch eine zeitliche Auflösung durch einen entsprechenden Austausch des TDC-Funktionsmoduls ist denkbar.

Weiter kann eine Ausgestaltungsform der optoelektrische Vorrichtung auch dadurch gekennzeichnet sein, dass zusätzlich vorgesehene weitere Funktionsmodule der anwendungsspezifischen integrierten Schaltung zumindest eine der folgende Funktionalitäten bereitstellen:
- volatiler Speicherbaustein,
- Prozessorbaustein ohne KI,
- Prozessorbaustein mit KI**.**

Durch die erfindungsgemäße integrierte Schaltung gemäß dem ersten Aspekt der Erfindung ist in der erfindungsgemäßen optoelektrischen Vorrichtung ist neben der voranstehend bereits beschriebenen einfachen Änderung auch eine Erweiterung der entsprechenden optoelektrischen Vorrichtung besonders einfach ermöglichbar. Insbesondere können bei entsprechender Anforderung, beispielsweise auf Kundenwunsch, weitere Funktionsmodule auf dem Verdrahtungswafer als Teil der erfindungsgemäßen integrierten Schaltung vorgesehen sein. Hierbei kann die optoelektrische Vorrichtung zum Beispiel um die Funktion einer Zwischenspeicherung von Messdaten in einem volatilen Speicherbaustein, oder einer durch einen Prozessor durchgeführten Bearbeitung der Messdaten, beispielsweise bereits das Errechnen einer Distanz aus den im TDC-Funktionsmodul erzeugten digitalen Zeitsignal, erweitert werden. Ein als Prozessorbaustein ausgebildetes Funktionsmodul kann hierbei mit und ohne Einbeziehung einer KI-Funktion (künstliche Intelligenz) realisiert sein.

Zusammenfassend kann in einer erfindungsgemäßen optoelektrischen Vorrichtung durch den Einsatz einer erfindungsgemäßen anwendungsspezifischen integrierten Schaltung die Gesamtfunktionalität einer Flugzeit-Distanzmessung besonders einfach erweitert werden.

Gemäß einer alternativen Ausführungsform kann bei der erfindungsgemäßen optoelektrischen Vorrichtung auch vorgesehen sein, dass die optoelektrische Vorrichtung für einen Einsatz in einer optischen Schalteinheit vorgesehen ist, und wobei das Photonikmodul eine oder mehrere Fotodioden aufweist, und die weiteren Funktionsmodule der integrierten Schaltung zumindest folgende Funktionalitäten bereitstellen:
- TIA (transimpedance amplifier),
- ADC (analog to digital converter),
- Kontrolleinheit (Datennahme),
- Spannungsversorgung,
- Kontrolleinheit (Spannungsversorgung),
- Schnittstelleneinheit (Spannungsversorgung).

Eine optische Schalteinheit zeichnet sich insbesondere dadurch aus, dass die Schalteinheit zwischen zumindest zwei Schaltzuständen schaltbar ist beziehungsweise schaltet, und dass ein Empfang beziehungsweise eine Detektion von Licht oder eines Lichtsignals einen Wechsel des vorliegenden Schaltzustands der Schalteinheit ausgelöst.

Durch ein Photonikmodul mit einer oder mehreren Fotodioden kann in der erfindungsgemäßen anwendungsspezifischen integrierten Schaltung das Detektieren von Licht beziehungsweise von Lichtsignalen ermöglicht werden. Durch den Einsatz mehrerer Fotodioden kann eine Empfindlichkeit der optischen Schalteinheit weiter gesteigert werden.

Ferner sind auf der erfindungsgemäßen integrierten Schaltung durch weitere Funktionsmodule vorgesehen, die als Funktionalitäten einen TIA (transimpedance amplifier, auch mit "current-to-voltage-converter" bezeichnet), einen ADC (analog to digital converter), eine Kontrolleinheit für die Datennahme, sowie eine Spannungsversorgung nebst entsprechender Schnittstelle und Kontrolleinheit bereitstellen.

Durch das TIA-Funktionsmodul wird das durch das Photonikmodul bereitgestellte Stromsignal, das eine Detektion von Licht oder eines Lichtsignals aufzeigt, in ein Spannungssignal umgewandelt, und dann im ADC-Funktionsmodul dieses Spannungssignal in digitale Werte umgewandelt. Die TIA-Funktionalität und die ADC-Funktionalität kann hierbei auch in einem gemeinsamen Funktionsmodul kombiniert vorgesehen sein. Beide Vorgänge werden durch die Kontrolleinheit für die Datennahme gesteuert und ausgelesen.

Die Spannungsversorgung und die entsprechend zugehörige Schnittstelle und Kontrolleinheit sorgen für die Versorgung der erfindungsgemäßen integrierten Schaltung mit elektrischer Energie. Diese die Spannungsversorgung betreffenden Funktionalitäten können durch jeweils ein Funktionsmodul, wahlweise aber auch durch ein oder mehrere Funktionsmodule mit kombinierten Funktionalitäten bereitgestellt werden.

Zusammenfassend kann in einer erfindungsgemäßen optoelektrischen Vorrichtung durch den Einsatz einer erfindungsgemäßen anwendungsspezifischen integrierten Schaltung die Gesamtfunktionalität einer optischen Schalteinheit besonders einfach und kompakt bereitgestellt werden. Wie bereits voranstehend mit Bezug auf die für einen Einsatz in einer Flugzeit-Distanzmessvorrichtung ausgebildete erfindungsgemäße optoelektrische Vorrichtung ausgeführt, kann analog auch bei der als optische Schalteinheit vorgesehene Variante der erfindungsgemäßen optoelektrischen Vorrichtung eine Anpassung der erfindungsgemäßen anwendungsspezifischen integrierten Schaltung der optoelektrischen Vorrichtung an geänderte Rahmenbedingungen mit besonders geringem Aufwand vorgenommen werden, ohne insbesondere die integrierte Schaltung von Grund auf neu designen zu müssen.

Auch kann bei der erfindungsgemäßen optoelektrische Vorrichtung ferner vorgesehen sein, dass zusätzlich vorgesehene weitere Funktionsmodule der anwendungsspezifischen integrierten Schaltung zumindest eine der folgende Funktionalitäten bereitstellen:
- nicht-volatiler Speicherbaustein,
- Prozessorbaustein ohne KI,
- Prozessorbaustein mit KI.

Durch das Vorhandensein einer erfindungsgemäßen integrierten Schaltung gemäß dem ersten Aspekt der Erfindung ist auch bei einer als optische Schalteinheit vorgesehenen erfindungsgemäßen optoelektrischen Vorrichtung eine Erweiterung der entsprechenden optoelektrischen Vorrichtung besonders einfach ermöglichbar. Insbesondere können bei entsprechender Anforderung, beispielsweise auf Kundenwunsch, weitere Funktionsmodule auf dem Verdrahtungswafer als Teil der erfindungsgemäßen anwendungsspezifischen integrierten Schaltung vorgesehen sein. Hierbei kann die optoelektrische Vorrichtung zum Beispiel um die Funktion einer Speicherung von Auslöseschwellen und/oder Erkennungsmustern in einem nicht-volatilen Speicherbaustein, oder einer durch einen Prozessor durchgeführten Bearbeitung der Messdaten, beispielsweise ein Vergleich mit den im Speicherbaustein hinterlegten Daten, erweitert werden. Ein als Prozessorbaustein ausgebildetes Funktionsmodul kann hierbei erneut mit und ohne Einbeziehung einer KI-Funktion (künstliche Intelligenz) realisiert sein.

Zusammenfassend kann in einer erfindungsgemäßen optoelektrischen Vorrichtung durch den Einsatz einer erfindungsgemäßen anwendungsspezifischen integrierten Schaltung die Gesamtfunktionalität einer optischen Schalteinheit besonders einfach erweitert werden.

Im Folgenden werden anhand von Ausführungsformen der erfindungsgemäßen optoelektrischen Vorrichtung beziehungsweise der erfindungsgemäßen anwendungsspezifischen integrierten Schaltung anhand von schematischen Figuren beispielhaft beschrieben. Es zeigen im Einzelnen
- Fig. 1: eine allgemeine Ausführungsform einer erfindungsgemäßen optoelektrischen Vorrichtung,
- Fig. 2: eine Ausführungsform einer erfindungsgemäßen optoelektrischen Vorrichtung für einen Einsatz in einer Flugzeit-Distanzmessvorrichtung, und
- Fig. 3: eine Ausführungsform einer erfindungsgemäßen optoelektrischen Vorrichtung für einen Einsatz in einer optischen Schalteinheit.

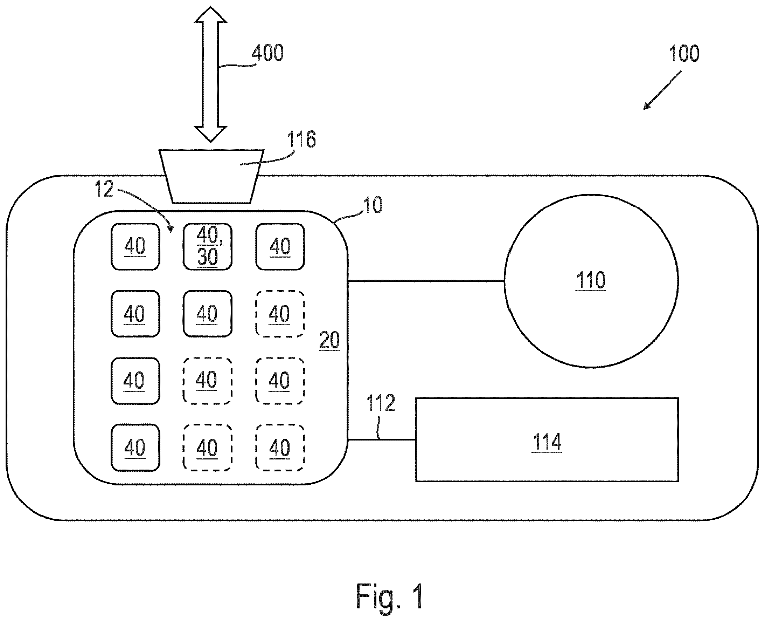

Fig. 1 zeigt schematisch eine erfindungsgemäße optoelektrische Vorrichtung 100 in einer vereinfachten Darstellung. Hauptbauteil der optoelektrischen Vorrichtung 100 ist eine erfindungsgemäße anwendungsspezifische integrierte Schaltung 10 mit einem photonischen System 12. Weiter weist die abgebildete optoelektrische Vorrichtung 100 eine Energieversorgung 110 sowie eine Datenschnittstelle 112 zum Betreiben der integrierten Schaltung 10 auf. Darüber hinaus kann die optoelektrische Vorrichtung 100 auch weitere optionale Bauelemente aufweisen, wie dargestellt zum Beispiel eine Ausgabeeinheit 114 und/oder eine Abbildungsoptik 116.

Die erfindungsgemäße anwendungsspezifische integrierte Schaltung 10 zeichnet sich insbesondere dadurch aus, dass sie einen Verdrahtungswafer 20 aufweist, auf denen verschiedene Funktionsmodule 40 angeordnet sind. Der Verdrahtungswafer 20 und die Funktionsmodule 40 sind insbesondere getrennt voneinander gefertigt. Die Funktionsmodule 40 sind für den spezifischen Einsatzzweck der jeweiligen anwendungsspezifischen integrierten Schaltung 10 passend wählbare Halbleiterbausteine, wobei insbesondere jeweils auch ein Halbleitermaterial der einzelnen Funktionsmodule 40 passend gewählt sein kann. Die Funktionsmodule 40 werden auf dem Verdrahtungswafer 20 platziert und dann mit und durch den Verdrahtungswafer 20 elektrisch verschaltet. Diese Funktionsmodule 40 können auch als Chiplets bezeichnet werden. Der Verdrahtungswafer 20 kann bevorzugt aus Silizium gefertigt sein.

Zumindest ein erstes dieser Funktionsmodule 40 ist als ein Photonikmodul 30 ausgebildet, durch das eine Manipulation von Licht 400 im Sinne eines Empfangens, Aussendens, Modulierens und/oder Leitens ermöglicht ist. Mit anderen Worten, dieses Photonikmodul 30 stellt zumindest einen Hauptbestandteil des photonischen Systems 12 der erfindungsgemäßen anwendungsspezifischen integrierten Schaltung 10 dar. Durch entsprechende Beschichtungen und/oder Filter (nicht mit abgebildet) können die optischen Eigenschaften des Photonikmoduls 30 beeinflusst beziehungsweise gezielt eingestellt sein.

Bevorzugt kann die anwendungsspezifische integrierte Schaltung 10 durch ein erfindungsgemäßes Verfahren hergestellt sein. Dafür wird in einem ersten Schritt a) ein Anforderungsprofil erstellt, das die Leistungsfähigkeit und Funktionen der geplanten anwendungsspezifische integrierte Schaltung 10 widerspiegelt. Im folgenden Schritt b) werden dann unter Berücksichtigung des erstellten Anforderungsprofils ein Verdrahtungswafer 20 und passende Halbleiterbausteine als Funktionsmodule 40 ausgewählt, wobei insbesondere wenigsten das erste Funktionsmodul 40 ein Photonikmodul 30 ist. Anschließend erfolgt im Schritt c) ein Platzieren der Funktionsmodule 40 auf dem Verdrahtungswafer 20 sowie im abschließenden Schritt d) das elektrische Verschalten dieser Komponenten.

Bei einer Änderung des Anforderungsprofils weist das erfindungsgemäße Verfahren insbesondere den Vorteil auf, dass nur das beziehungsweise die Funktionsmodule 40, das/die von der Änderung betroffen ist/sind, bei der Herstellung der entsprechenden anwendungsspezifischen integrierten Schaltung 10 ausgetauscht werden müssen, mit anderen Worten in Schritt b) des erfindungsgemäßen Verfahrens entsprechend ausgewählt werden müssen. Die restlichen Komponenten der anwendungsspezifischen integrierten Schaltung 10 können unverändert bleiben. Eine komplette Neuentwicklung der anwendungsspezifischen integrierten Schaltung 10 bei einer Änderung des Anforderungsprofils kann dadurch vermieden werden.

Wie durch die teilweise strichlierte Darstellung der Funktionsmodule 40 in Fig. 1 dargestellt, können diese, wie oben bereits beschrieben, je nach den vorherrschenden Rahmenbedingungen und Anforderungen an die optoelektrische Vorrichtung 100 ausgewählt und in der erfindungsgemäßen anwendungsspezifischen integrierten Schaltung 10 verwendet werden. Eine hohe Flexibilität und Anpassungsfähigkeit der erfindungsgemäßen anwendungsspezifischen integrierten Schaltung 10, und damit auch einer erfindungsgemäßen optoelektrischen Vorrichtung 100, kann dadurch ermöglicht werden, insbesondere ohne ein völliges Neudesign der verwendeten anwendungsspezifischen integrierten Schaltung 10 zu erfordern.

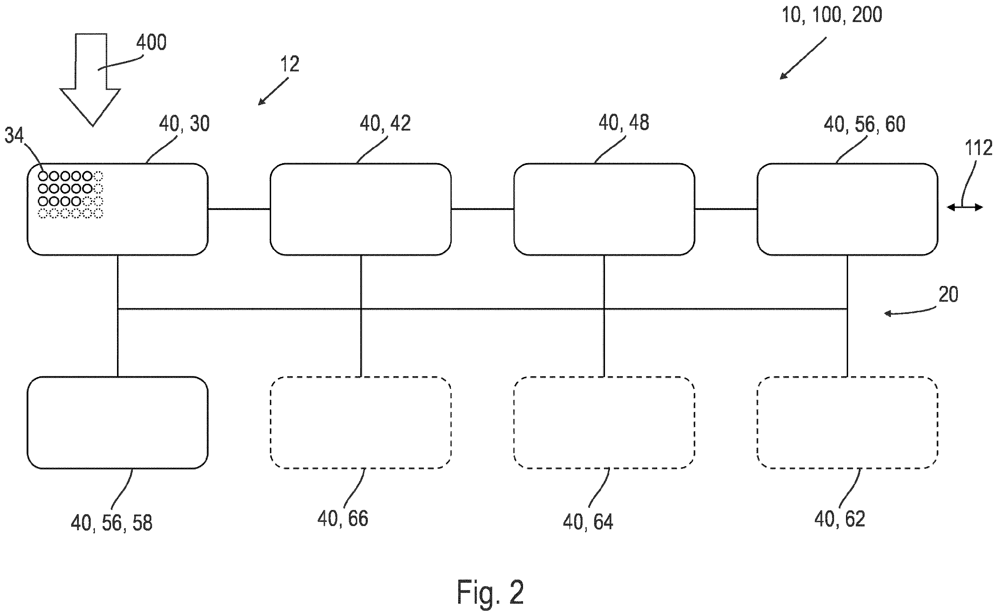

In Fig. 2 ist eine derartige erfindungsgemäße anwendungsspezifische integrierte Schaltung 10 gezeigt, deren photonisches System 12 insbesondere für einen Einsatz in einer als Flugzeit-Distanzmessvorrichtung 200 ausgebildeten erfindungsgemäßen optoelektrischen Vorrichtung 100 vorgesehen ist. Dafür weist insbesondere das Photonikmodul 30 mehrere Avalanche-Fotodioden 34, bevorzugt Einzelphotonen-Avalanche-Fotodioden 34, auf, die zusammen ein mehrzeiliges Array bilden. Die Anzahl der Avalanche-Fotodioden 34 ist, gekennzeichnet durch die strichlierte Darstellung am Rand des Arrays, nicht abschließend dargestellt. Im Ergebnis kann durch das Photonikmodul 30 einfallendes Licht 400 detektiert werden.

Im vorliegenden Fall einer Flugzeit-Distanzmessvorrichtung 200 handelt es sich bei diesem Licht 400 insbesondere um ein an einem Objekt reflektiertes Licht 400, wobei dieses Licht 400 durch die Flugzeit-Distanzmessvorrichtung 200 selbst ausgesendet wurde. Um die notwendige Funktionalität für diese Flugzeit-Distanzmessvorrichtung 200 bereitzustellen, weist die verwendete erfindungsgemäße anwendungsspezifische integrierte Schaltung 10 weitere Funktionsmodule 40 auf, nämlich insbesondere Funktionsmodule 40 mit den Funktionalitäten eines TDC 42, einer Kontrolleinheit für die Datennahme 48, sowie einer Stromversorgung 56, wobei die Stromversorgung 56 durch je ein separates Funktionsmodul 40 für eine Kontrolleinheit 58 der Stromversorgung 56 und eine Schnittstelleneinheit 60 der Stromversorgung 56 gebildet ist. Die Schnittstelleneinheit 60 der Stromversorgung 56 fungiert gleichzeitig als Übertragungspunkt von Daten, und ist daher mit der Datenschnittstelle 112 der restlichen optoelektrischen Vorrichtung 100 datenkommunizierend verbunden.

Optional können weitere Funktionsmodule 40 vorgesehen sein, gekennzeichnet durch eine strichlierte Darstellung. So können, falls erforderlich oder gewünscht, auch Funktionsmodule 40 mit der Funktionalität eines volatilen Speicherbausteins 66, und/oder eines Prozessorbausteins ohne KI 62 beziehungsweise eines Prozessorbausteins mit KI 64 vorgesehen sein.

Gesteuert durch das Funktionsmodul 40, das die Funktionalität einer Kontrolleinheit 48 für die Datennahme bereitstellt, wird durch das TDC-Funktionsmodul 40, 42 eine Zeit zwischen einem Aussenden des Lichts 400 durch die optoelektrische Vorrichtung 100 und einem Empfang des an einem Objekt reflektierten Lichts 400 durch das Photonikmodul 30 ermittelt. Dieser Messwert kann als Ergebnis des TDC-Funktionsmoduls 40, 42 direkt als digitaler Wert über die Datenschnittstelle 112 bereitgestellt werden. Alternativ kann dieser Messwert auch, wenn vorhanden, durch ein als Prozessorbaustein 62, 64 ausgebildetes Funktionsmodul 40 ausgewertet und/oder in einem als Speicherbaustein 66 ausgebildeten Funktionsmodul 40 abgespeichert werden.

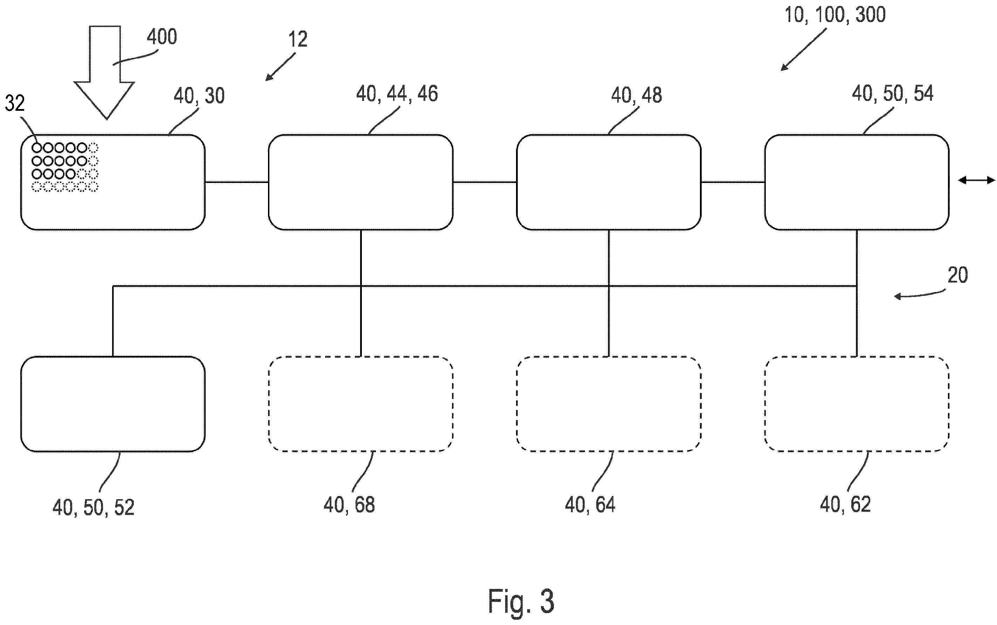

Fig. 3 zeigt eine alternative Ausgestaltung der erfindungsgemäßen photoelektrischen Vorrichtung 100 mit einer erfindungsgemäßen anwendungsspezifischen integrierten Schaltung 10, die insgesamt als optische Schalteinheit 300 eingesetzt werden soll. Ähnlich wie die in Fig. 2 gezeigte integrierte Schaltung 10 weist auch die in Fig. 3 dargestellte Variante der erfindungsgemäßen anwendungsspezifischen integrierten Schaltung 10 ein als Photonikmodul 30 ausgestaltetes erstes Funktionsmodul 40 auf. Dieses ist jedoch mit einer Mehrzahl an Fotodioden 32 ausgeformt, die in einem mehrzeiligen Array angeordnet sind. Alternativ können, falls dies der Anforderung an die optoelektrische Vorrichtung 100 ermöglicht, auch Photonikmodule 30 mit einzelnen Fotodioden 32 eingesetzt werden.

Um die notwendige Funktionalität für eine optische Schalteinheit 300 bereitzustellen, weist die verwendete erfindungsgemäße anwendungsspezifische integrierte Schaltung 10 weitere Funktionsmodule 40 auf, nämlich insbesondere Funktionsmodule 40 mit den kombinierten Funktionalitäten eines TIA 44 und eines ADCs 46, und weiter mit der Funktionalität einer Kontrolleinheit für die Datennahme 48, sowie einer Spannungsversorgung 50. Analog zur Stromversorgung 56 im oben mit Bezug auf Fig. 2 beschriebenen Beispiel ist die in Fig. 3 gezeigte Spannungsversorgung 50 durch je ein separates Funktionsmodul 40 für eine Kontrolleinheit 52 der Spannungsversorgung 50 und eine Schnittstelleneinheit 54 der Spannungsversorgung 50 gebildet. Die Schnittstelleneinheit 54 der Spannungsversorgung 50 fungiert erneut gleichzeitig als Übertragungspunkt von Daten, und ist daher mit der Datenschnittstelle 112 der restlichen optoelektrischen Vorrichtung 100 datenkommunizierend verbunden.

Optional können auch hier weitere Funktionsmodule 40 vorgesehen sein, gekennzeichnet durch eine strichlierte Darstellung. So können, falls erforderlich oder gewünscht, auch Funktionsmodule 40 mit der Funktionalität eines nicht-volatilen Speicherbausteins 68, oder eines Prozessorbausteins ohne KI 62 beziehungsweise eines Prozessorbausteins mit KI 64 vorgesehen sein.

Gesteuert durch das Funktionsmodul 40, das die Funktionalität einer Kontrolleinheit 48 für die Datennahme bereitstellt, wird eine Detektion von einfallendem Licht 400 durch die Fotodioden 32 des Photonikmoduls 30 erkannt. Der durch das Photonikmodul 30 ermittelte Messwert kann, nach Verarbeitung im TIA/ADC Funktionsmodul 40, 44, 46 direkt über die Datenschnittstelle 112 bereitgestellt werden. Alternativ kann dieser Messwert auch, wenn vorhanden, durch ein als Prozessorbaustein 62, 64 ausgebildetes Funktionsmodul 40 ausgewertet werden, beispielsweise durch einen Vergleich mit in einem als Speicherbaustein 68 abgelegten Auslöseschwellen und/oder Erkennungsmustern.

In beiden in Fig. 2, 3 gezeigten Beispielen, aber nicht darauf beschränkt, kann durch den modularen Aufbau der erfindungsgemäßen anwendungsspezifischen integrierten Schaltung 10 je nach Anforderung ein Austausch eines oder mehrerer Funktionsmodule 40, insbesondere auch des Photonikmoduls 30, vorgenommen werden, ohne die gesamte anwendungsspezifische integrierte Schaltung 10 neu designen zu müssen. Eine Anpassung der erfindungsgemäßen anwendungsspezifischen integrierten Schaltung 10, und damit eines damit ausgestatteten erfindungsgemäßen photoelektrischen Systems 100 kann dadurch einfach und insbesondere mit geringem Aufwand an Kosten und Zeit ermöglicht werden.

So kann beispielsweise bei einer optoelektrischen Vorrichtung 100 zum Detektieren von Licht 400 mit einer hohen Empfindlichkeit im Bereich von sichtbarem Licht 400 um 700 nm ein Photonikmodul 30 mit Silizium (Si) als Detektions-Halbleitermaterial verwendet werden. Bei einer Änderung einer Anforderung an die optoelektrische Vorrichtung 100 dahingehend, dass diese eine hohe Empfindlichkeit im Bereich von Infrarot-Licht 400 um 1300 nm aufweisen soll, reicht es aus, ein Photonikmodul 30 mit Indiumphosphid (InP) als Detektions-Halbleitermaterial zu verwenden. Allein durch Austausch des Photonikmoduls 30 der anwendungsspezifischen integrierten Schaltung 10, und insbesondere bevorzugt ohne Änderung der restlichen Funktionsmodule 40, kann somit das photonische System 12 der anwendungsspezifischen Schaltung 10, und damit die gesamte optoelektrische Vorrichtung 100, auf neue, sich ändernde Anforderungen abgestimmt bereitgestellt werden.

### Bezugszeichen

- 10: Anwendungsspezifische integrierte Schaltung
- 12: Photonisches System

- 20: Verdrahtungswafer

- 30: Photonikmodul
- 32: Fotodiode
- 34: Avalanche-Fotodiode

- 40: Funktionsmodul
- 42: TDC
- 44: TIA
- 46: ADC
- 50: Spannungsversorgung
- 52: Kontrolleinheit (Spannungsversorgung)
- 54: Schnittstelleneinheit (Spannungsversorgung)
- 56: Stromversorgung
- 58: Kontrolleinheit (Stromversorgung)
- 60: Schnittstelleneinheit (Stromversorgung)
- 62: Prozessorbaustein ohne KI
- 64: Prozessorbaustein mit KI
- 66: volatiler Speicherbaustein
- 68: nicht-volatiler Speicherbaustein

- 100: Optoelektrische Vorrichtung

- 110: Energieversorgung
- 112: Datenschnittstelle
- 114: Ausgabeeinheit
- 116: Abbildungsoptik

- 200: Flugzeit-Distanzmessvorrichtung

- 300: optische Schalteinheit

- 400: Licht

## Patentansprüche

1. Anwendungsspezifische integrierte Schaltung (10) mit einem photonischen System (12),
**dadurch gekennzeichnet,**
**dass** die anwendungsspezifische integrierte Schaltung (10) einen Verdrahtungswafer (20), ein erstes Funktionsmodul (40) und ein oder mehrere weitere Funktionsmodule (40) aufweist, wobei die Funktionsmodule (40) getrennt vom Verdrahtungswafer (20) gefertigt sind, und wobei zur Bildung der anwendungsspezifischen integrierten Schaltung (10) die Funktionsmodule (40) auf dem Verdrahtungswafer (20) platziert sowie durch und mit diesem elektrisch verschaltet sind, wobei ferner die Funktionsmodule (40) als Halbleiterbausteine ausgebildet sind und das erste Funktionsmodul (40) und zumindest eines der ein oder mehreren weiteren Funktionsmodule (40) unterschiedlich sind, und dass das photonische System (12) zumindest durch das erste Funktionsmodul (40) gebildet ist, wobei das erste Funktionsmodul (40) als Photonikmodul (30) zum Erzeugen und/oder Empfangen und/oder Modulieren und/oder Leiten von Licht (400) ausgebildet ist.

2. Anwendungsspezifische integrierte Schaltung (10) nach Anspruch 1,
**dadurch gekennzeichnet,**
**dass** das Photonikmodul (30) zumindest eine der folgenden Funktionalitäten bereitstellt:
- Detektieren von Licht (400),
- Aussenden von Licht (400), bevorzugt von Laserlicht (400),
- optisches Verstärken von Licht (400),
- Leiten von Licht (400),
- Verändern einer Phase und/oder einer Wellenlänge und/oder einer Polarisation von Licht (400),
wobei bevorzugt das Photonikmodul (30) eine zum Beeinflussen von optische Eigenschaften des Photonikmoduls (30) eine Reflexionsbeschichtung und/oder eine Antireflexionsbeschichtung und/oder einen Filter aufweist.

3. Anwendungsspezifische integrierte Schaltung (10) nach Anspruch 2,
**dadurch gekennzeichnet,**
**dass** das Photonikmodul (30) ein Detektieren von Licht (400) ermöglicht und dafür eine oder mehrere Fotodioden (32) und/oder eine oder mehrere Avalanche-Fotodioden (34), insbesondere Einzelphoton-Avalanche-Fotodioden (34), aufweist, wobei bevorzugt mehrere Fotodioden (32) und/oder mehrere Avalanche-Fotodioden (34) im Photonikmodul (30) in einer Reihe oder in einem mehrreihigen Array angeordnet sind.

4. Anwendungsspezifische integrierte Schaltung (10) nach einem der vorstehenden Ansprüche,
**dadurch gekennzeichnet,**
**dass** wenigstens eines der ein oder mehreren weiteren Funktionsmodule (40) zumindest eine der folgenden Funktionalitäten bereitstellt:
- TDC (time to digital converter) (42),
- TIA (transimpedance amplifier) (44),
- ADC (analog to digital converter) (46),
- Kontrolleinheit (Datennahme) (48),
- Spannungsversorgung (50),
- Kontrolleinheit (Spannungsversorgung) (52),
- Schnittstelleneinheit (Spannungsversorgung) (54),
- Stromversorgung (56),
- Kontrolleinheit (Stromversorgung) (58),
- Schnittstelleneinheit (Stromversorgung) (60),
- Prozessorbaustein ohne KI (62),
- Prozessorbaustein mit KI (64),
- volatiler Speicherbaustein (66),
- nicht-volatiler Speicherbaustein (68).

5. Anwendungsspezifische integrierte Schaltung (10) nach einem der vorstehenden Ansprüche,
**dadurch gekennzeichnet,**
**dass** der Verdrahtungswafer (20) Silizium aufweist, insbesondere aus Silizium, bevorzugt aus monokristallinem Silizium, besteht.

6. Verfahren zum Herstellen einer anwendungsspezifischen integrierten Schaltung (10) mit einem photonischen System (12) nach einem der Ansprüche 1 bis 5, **gekennzeichnet durch** folgende Schritte:
a) Erstellen eines Anforderungsprofils an die herzustellende anwendungsspezifische integrierte Schaltung (10),
b) Auswahl eines geeigneten Verdrahtungswafers (20) sowie von zwei oder mehr geeigneten Funktionsmodulen (40) basierend auf dem in Schritt a) erstellten Anforderungsprofils, wobei die Funktionsmodule (40) als Halbleiterbausteine ausgebildet und getrennt vom Verdrahtungswafer (20) gefertigt sind,
c) Platzieren der in Schritt b) ausgewählten Funktionsmodule (40) auf dem in Schritt b) ausgewählten Verdrahtungswafer (20), bevorzugt in einem Pick-and-Place-Verfahren,
d) Elektrisches Verschalten der in Schritt c) platzierten Funktionsmodule (40) mit und **durch** den Verdrahtungswafer (20),
wobei ein erstes Funktionsmodul (40) und zumindest eines der ein oder mehreren weiteren Funktionsmodule (40) unterschiedlich sind, und wobei zumindest das erste Funktionsmodul (40) das photonische System (12) bildet, wobei das erste Funktionsmodul (40) als Photonikmodul (30) zum Erzeugen und/oder Empfangen und/oder Modulieren und/oder Leiten von Licht (400) ausgebildet ist.

7. Verfahren nach Anspruch 6,
**dadurch gekennzeichnet,**
**dass** bei einer Änderung des in Schritt a) erstellten Anforderungsprofils im folgenden Schritt b) basierend auf dieser Änderung eine Anpassung der Auswahl der Funktionsmodule (40) erfolgt.

8. Optoelektrische Vorrichtung (100), aufweisend eine anwendungsspezifische integrierte Schaltung (10), eine Energieversorgung (110) für die anwendungsspezifische integrierte Schaltung (10) sowie eine Datenschnittstelle (112) für ein Ansteuern der anwendungsspezifischen integrierten Schaltung (10),
**dadurch gekennzeichnet,**
**dass** die anwendungsspezifische integrierte Schaltung (10) als eine anwendungsspezifische integrierte Schaltung (10) mit einem photonischen System (12) gemäß einem der vorstehenden Ansprüche 1 bis 5 ausgebildet und/oder durch ein Verfahren gemäß einem der vorstehenden Ansprüche 6 oder 7 hergestellt ist.

9. Optoelektrische Vorrichtung (100) nach Anspruch 8,
**dadurch gekennzeichnet,**
**dass** das photonische System (12) der integrierten Schaltung (10) durch zumindest ein zum Detektieren von Licht (400) ausgebildetes Photonikmodul (30) gebildet ist.

10. Optoelektrische Vorrichtung (100) nach Anspruch 9,
**dadurch gekennzeichnet,**
**dass** eine wellenlängenabhängige Empfindlichkeit der optoelektrischen Vorrichtung (100) durch ein zum Detektieren von Licht (400) eingesetztes Detektions-Halbleitermaterial des Photonikmoduls (30) eingestellt ist.

11. Optoelektrische Vorrichtung (100) nach Anspruch 10,
**dadurch gekennzeichnet,**
**dass** für eine hohe Empfindlichkeit der optoelektrischen Vorrichtung (100) im Bereich von sichtbarem Licht um 700 nm Silizium ein Photonikmodul (30) mit Silizium (Si) als Detektions-Halbleitermaterial verwendet ist, und dass für eine hohe Empfindlichkeit der optoelektrischen Vorrichtung (100) im Bereich von Infrarot-Licht um 1300 nm ein Photonikmodul (30) mit Indiumphosphid (InP) als Detektions-Halbleitermaterial verwendet ist.

12. Optoelektrische Vorrichtung (100) nach einem der Ansprüche 9 bis 11, **dadurch gekennzeichnet,**
**dass** die optoelektrische Vorrichtung (100) für einen Einsatz in einer Flugzeit-Distanzmessvorrichtung (200) vorgesehen ist, und wobei das Photonikmodul (30) eine oder mehrere Avalanche-Fotodioden (34), insbesondere Einzelphoton-Avalanche-Fotodioden (34), aufweist, und die weiteren Funktionsmodule (40) der integrierten Schaltung zumindest folgende Funktionalitäten bereitstellen:
- TDC (time to digital converter) (42),
- Kontrolleinheit (Datennahme) (48),
- Stromversorgung (56),
- Kontrolleinheit (Stromversorgung) (58),
- Schnittstelleneinheit (Stromversorgung) (60).

13. Optoelektrische Vorrichtung (100) nach Anspruch 12,
**dadurch gekennzeichnet,**
**dass** zusätzlich vorgesehene weitere Funktionsmodule (40) der anwendungsspezifischen integrierten Schaltung (10) zumindest eine der folgende Funktionalitäten bereitstellen:
- volatiler Speicherbaustein (66),
- Prozessorbaustein ohne KI (62),
- Prozessorbaustein mit KI (64).

14. Optoelektrische Vorrichtung (100) nach einem der Ansprüche 9 bis 11, **dadurch gekennzeichnet,**
**dass** die optoelektrische Vorrichtung (100) für einen Einsatz in einer optischen Schalteinheit (300) vorgesehen ist, und wobei das Photonikmodul (30) eine oder mehrere Fotodioden (32) aufweist, und die weiteren Funktionsmodule (40) der anwendungsspezifischen integrierten Schaltung (10) zumindest folgende Funktionalitäten bereitstellen:
- TIA (transimpedance amplifier) (44),
- ADC (analog to digital converter) (46),
- Kontrolleinheit (Datennahme) (48),
- Spannungsversorgung (50),
- Kontrolleinheit (Spannungsversorgung) (52),
- Schnittstelleneinheit (Spannungsversorgung) (54).

15. Optoelektrische Vorrichtung (100) nach Anspruch 14,
**dadurch gekennzeichnet,**
**dass** zusätzlich vorgesehene weitere Funktionsmodule (40) der integrierten Schaltung zumindest eine der folgende Funktionalitäten bereitstellen:
- nicht-volatiler Speicherbaustein (68),
- Prozessorbaustein ohne KI (62),
- Prozessorbaustein mit KI (64).

## Geänderte Patentansprüche

### Geänderte Patentansprüche gemäss Regel 137(2) EPÜ.

1. Verfahren zum Herstellen einer anwendungsspezifischen integrierten Schaltung (10) mit einem photonischen System (12), wobei die anwendungsspezifische integrierte Schaltung (10) einen Verdrahtungswafer (20), ein erstes Funktionsmodul (40) und ein oder mehrere weitere Funktionsmodule (40) aufweist, **gekennzeichnet durch** folgende Schritte:
a) Erstellen eines Anforderungsprofils an die herzustellende anwendungsspezifische integrierte Schaltung (10),
b) Auswahl eines geeigneten Verdrahtungswafers (20) sowie von zwei oder mehr geeigneten Funktionsmodulen (40) basierend auf dem in Schritt a) erstellten Anforderungsprofils, wobei die Funktionsmodule (40) als Halbleiterbausteine ausgebildet und getrennt vom Verdrahtungswafer (20) gefertigt sind,
c) Platzieren der in Schritt b) ausgewählten Funktionsmodule (40) auf dem in Schritt b) ausgewählten Verdrahtungswafer (20),
d) Elektrisches Verschalten der in Schritt c) platzierten Funktionsmodule (40) mit und **durch** den Verdrahtungswafer (20),
wobei ein erstes Funktionsmodul (40) und zumindest eines der ein oder mehreren weiteren Funktionsmodule (40) unterschiedlich sind, und wobei zumindest das erste Funktionsmodul (40) das photonische System (12) bildet, wobei das erste Funktionsmodul (40) als Photonikmodul (30) zum Erzeugen und/oder Empfangen und/oder Modulieren und/oder Leiten von Licht (400) ausgebildet ist
**dadurch** gekennzeichnet,
dass bei einer Änderung des in Schritt a) erstellten Anforderungsprofils im folgenden Schritt b) basierend auf dieser Änderung eine Anpassung der Auswahl der Funktionsmodule (40) erfolgt.

2. Anwendungsspezifische integrierte Schaltung (10) mit einem photonischen System (12),
wobei die anwendungsspezifische integrierte Schaltung (10) einen Verdrahtungswafer (20), ein erstes Funktionsmodul (40) und ein oder mehrere weitere Funktionsmodule (40) aufweist, wobei die Funktionsmodule (40) getrennt vom Verdrahtungswafer (20) gefertigt sind, und wobei zur Bildung der anwendungsspezifischen integrierten Schaltung (10) die Funktionsmodule (40) auf dem Verdrahtungswafer (20) platziert sowie durch und mit diesem elektrisch verschaltet sind, wobei ferner die Funktionsmodule (40) als Halbleiterbausteine ausgebildet sind und das erste Funktionsmodul (40) und zumindest eines der ein oder mehreren weiteren Funktionsmodule (40) unterschiedlich sind, und dass das photonische System (12) zumindest durch das erste Funktionsmodul (40) gebildet ist, wobei das erste Funktionsmodul (40) als Photonikmodul (30) zum Erzeugen und/oder Empfangen und/oder Modulieren und/oder Leiten von Licht (400) ausgebildet ist,
**dadurch gekennzeichnet, dass**
die anwendungsspezifische Schaltung (10) durch ein Verfahren nach Anspruch 1 hergestellt ist.

3. Anwendungsspezifische integrierte Schaltung (10) nach Anspruch 2,
**dadurch gekennzeichnet,**
**dass** das Photonikmodul (30) zumindest eine der folgenden Funktionalitäten bereitstellt:
- Detektieren von Licht (400),
- Aussenden von Licht (400),
- optisches Verstärken von Licht (400),
- Leiten von Licht (400),
- Verändern einer Phase und/oder einer Wellenlänge und/oder einer Polarisation von Licht (400).

4. Anwendungsspezifische integrierte Schaltung (10) nach Anspruch 3, **dadurch gekennzeichnet,**
**dass** das Photonikmodul (30) ein Detektieren von Licht (400) ermöglicht und dafür eine oder mehrere Fotodioden (32) und/oder eine oder mehrere Avalanche-Fotodioden (34) aufweist.

5. Anwendungsspezifische integrierte Schaltung (10) nach einem der vorstehenden Ansprüche 2 bis 4,
**dadurch gekennzeichnet,**
**dass** wenigstens eines der ein oder mehreren weiteren Funktionsmodule (40) zumindest eine der folgenden Funktionalitäten bereitstellt:
- TDC (time to digital converter) (42),
- TIA (transimpedance amplifier) (44),
- ADC (analog to digital converter) (46),
- Kontrolleinheit für eine Datennahme (48),
- Spannungsversorgung (50),
- Kontrolleinheit der Spannungsversorgung (52),
- Schnittstelleneinheit der Spannungsversorgung (54),
- Stromversorgung (56),
- Kontrolleinheit der Stromversorgung (58),
- Schnittstelleneinheit der Stromversorgung (60),
- Prozessorbaustein ohne KI (62),
- Prozessorbaustein mit KI (64),
- volatiler Speicherbaustein (66),
- nicht-volatiler Speicherbaustein (68).

6. Anwendungsspezifische integrierte Schaltung (10) nach einem der vorstehenden Ansprüche 2 bis 5,
**dadurch gekennzeichnet,**
**dass** der Verdrahtungswafer (20) Silizium aufweist.

7. Optoelektrische Vorrichtung (100), aufweisend eine anwendungsspezifische integrierte Schaltung (10), eine Energieversorgung (110) für die anwendungsspezifische integrierte Schaltung (10) sowie eine Datenschnittstelle (112) für ein Ansteuern der anwendungsspezifischen integrierten Schaltung (10),
**dadurch gekennzeichnet,**
**dass** die anwendungsspezifische integrierte Schaltung (10) als eine anwendungsspezifische integrierte Schaltung (10) mit einem photonischen System (12) gemäß einem der vorstehenden Ansprüche 2 bis 6 ausgebildet und/oder durch ein Verfahren gemäß Anspruch 1 hergestellt ist.

8. Optoelektrische Vorrichtung (100) nach Anspruch 7,
**dadurch gekennzeichnet,**
**dass** das photonische System (12) der integrierten Schaltung (10) durch zumindest ein zum Detektieren von Licht (400) ausgebildetes Photonikmodul (30) gebildet ist.

9. Optoelektrische Vorrichtung (100) nach Anspruch 8,
**dadurch gekennzeichnet,**
**dass** eine wellenlängenabhängige Empfindlichkeit der optoelektrischen Vorrichtung (100) durch ein zum Detektieren von Licht (400) eingesetztes Detektions-Halbleitermaterial des Photonikmoduls (30) eingestellt ist.

10. Optoelektrische Vorrichtung (100) nach Anspruch 9,
**dadurch gekennzeichnet,**
**dass** für eine hohe Empfindlichkeit der optoelektrischen Vorrichtung (100) im Bereich von sichtbarem Licht um 700 nm Silizium ein Photonikmodul (30) mit Silizium (Si) als Detektions-Halbleitermaterial verwendet ist, und dass für eine hohe Empfindlichkeit der optoelektrischen Vorrichtung (100) im Bereich von Infrarot-Licht um 1300 nm ein Photonikmodul (30) mit Indiumphosphid (InP) als Detektions-Halbleitermaterial verwendet ist.

11. Optoelektrische Vorrichtung (100) nach einem der Ansprüche 8 bis 10,
**dadurch gekennzeichnet,**
**dass** die optoelektrische Vorrichtung (100) für einen Einsatz in einer Flugzeit-Distanzmessvorrichtung (200) vorgesehen ist, und wobei das Photonikmodul (30) eine oder mehrere Avalanche-Fotodioden (34) aufweist, und die weiteren Funktionsmodule (40) der integrierten Schaltung zumindest folgende Funktionalitäten bereitstellen:
- TDC (time to digital converter) (42),
- Kontrolleinheit für eine Datennahme (48),
- Stromversorgung (56),
- Kontrolleinheit der Stromversorgung (58),
- Schnittstelleneinheit der Stromversorgung (60).

12. Optoelektrische Vorrichtung (100) nach Anspruch 11,
**dadurch gekennzeichnet,**
**dass** zusätzlich vorgesehene weitere Funktionsmodule (40) der anwendungsspezifischen integrierten Schaltung (10) zumindest eine der folgende Funktionalitäten bereitstellen:
- volatiler Speicherbaustein (66),
- Prozessorbaustein ohne KI (62),
- Prozessorbaustein mit KI (64).

13. Optoelektrische Vorrichtung (100) nach einem der Ansprüche 8 bis 10,
**dadurch gekennzeichnet,**
**dass** die optoelektrische Vorrichtung (100) für einen Einsatz in einer optischen Schalteinheit (300) vorgesehen ist, und wobei das Photonikmodul (30) eine oder mehrere Fotodioden (32) aufweist, und die weiteren Funktionsmodule (40) der anwendungsspezifischen integrierten Schaltung (10) zumindest folgende Funktionalitäten bereitstellen:
- TIA (transimpedance amplifier) (44),
- ADC (analog to digital converter) (46),
- Kontrolleinheit für eine Datennahme (48),
- Spannungsversorgung (50),
- Kontrolleinheit der Spannungsversorgung (52),
- Schnittstelleneinheit der Spannungsversorgung (54).

14. Optoelektrische Vorrichtung (100) nach Anspruch 13,
**dadurch gekennzeichnet,**
**dass** zusätzlich vorgesehene weitere Funktionsmodule (40) der integrierten Schaltung zumindest eine der folgende Funktionalitäten bereitstellen:
- nicht-volatiler Speicherbaustein (68),
- Prozessorbaustein ohne KI (62),
- Prozessorbaustein mit KI (64).
